Europäisches Patentamt

European Patent Office

Office européen des brevets

(19)

(11) Publication number: **0 167 392 B1**

# EUROPEAN PATENT SPECIFICATION

(12)

(45) Date of publication of patent specification: **13.05.92**

(51) Int. Cl.⁵: **H01L 41/22**, H01L 41/08

(21) Application number: **85304723.1**

(22) Date of filing: **02.07.85**

(54) **Method of producing electrostrictive effect element.**

(30) Priority: **02.07.84 JP 136763/84**

(43) Date of publication of application:
**08.01.86 Bulletin 86/02**

(45) Publication of the grant of the patent:
**13.05.92 Bulletin 92/20**

(84) Designated Contracting States:
**DE FR GB NL**

(56) References cited:
**EP-A- 0 094 078**
**EP-A- 0 113 999**

(73) Proprietor: **NEC CORPORATION**
**7-1, Shiba 5-chome Minato-ku**
**Tokyo 108-01(JP)**

(72) Inventor: **Utsumi, Kazuaki**
**c/o NEC Corporation 33-1, Shiba 5-chome**
**Minato-ku Tokyo(JP)**
Inventor: **Suzuki, Masanori**
**c/o NEC Corporation 33-1, Shiba 5-chome**
**Minato-ku Tokyo(JP)**
Inventor: **Ochi, Atsushi**
**c/o NEC Corporation 33-1, Shiba 5-chome**
**Minato-ku Tokyo(JP)**

(74) Representative: **Pritchard, Colin Hubert et al**
**Mathys & Squire 10 Fleet Street**
**London EC4Y 1AY(GB)**

EP 0 167 392 B1

## Description

The present invention relates to a method of producing a laminated-type electrostrictive effect element which makes use of longitudinal electrostrictive effect.

The United States Patent No. 4,523,121 discloses a laminated-type electrostrictive effect element having a plurality of thin plates made of an electrostrictive material and a plurality of internal electrodes superposed alternatingly, the internal electrodes of every other layers being connected in series and supplied with positive and negative voltages, respectively, by an external power supply so as to produce a longitudinal electrostrictive strain in the direction of lamination. Because of the use of the thin electrostrictive plates, this laminated-type electrostrictive effect element can operate with a sufficiently low voltage. In addition, a large strain effect, i.e., a large displacement, is ensured due to the laminated structure. For these reasons, this electrostrictive effect element is expected to find various uses in a printer head of an impact printer, in a relay and so forth.

In the above-mentioned United States Patent, it is proposed to screen-print epoxy resin onto the exposed side ends of the internal electrodes which are not to be connected electrically. However, such screen-printed organic material exhibits an inferior adhesion to ceramics, metals or the like material. In addition, since the thickness of each electrostrictive layer is very thin, the screen-printing is required a high precision for the alignment and thus is difficult to be reduced into practice.

Accordingly, an object of the invention is provide a method of producing an electrostrictive effect element to achieve a high reliability and long life time with a high electrostrictive effect of the element.

According to the invention, there is provided a method of producing an electrostrictive effect element comprising the steps of: preparing a laminated structure in which a plurality of films or thin plates of electrostrictive material alternate with a plurality of layers of internal electrodes, each film or plate has a principal surface thereof facing a principal surface of a layer, and said laminated structure has flat side surfaces which are perpendicular to said principal surfaces and upon which cross sections of said internal electrodes are exposed; and selectively depositing organic material on the exposed cross sections or on portions of the exposed cross sections of said internal electrodes and on adjacent areas of the electrostrictive material; characterised by depositing said organic material by an electrophoretic process after placing said laminated structure in a solution containing said organic material; and thereafter sintering the deposited organic material to produce organic insulation layers.

By using a method according to the invention, it is possible to obtain an electrostrictive effect element having organic insulating layers which exhibit good insulation properties and reliability, without imparing the expansion and contraction of the electrostrictive effect elements and without suffering from cracking due to the expansion and construction of the electrostrictive effect element.

The invention will now be described, by way of example, with reference to the accompanying drawings, in which:-

Figure 1 is a schematic sectional view of a laminated-type electrostrictive effect element shown in the prior art.

Figure 2 is a plan view of the element of Figure 1.

Figure 3 is a perspective view of a first embodiment of the invention.

Figure 4 is a sectional view of the first embodiment.

Fig. 5 is a sectional view of an example of the apparatus used for forming an insulating layer by electrophoretic method according to the invention.

Fig. 6 shows a perspective view of a laminated structure before the insulating layers are deposited in a second embodiment of the invention.

Figs. 7 and 8 show a perspective view of the laminated structure on which epoxy layers are formed on the exposed portions of the internal electrodes and on the electrostrictive material adjacent thereto in the second embodiment.

Fig. 9 shows a perspective view of an electrostrictive effect element cut out from the portion shown by broken line in Fig. 8 and provided with external electrodes in the second embodiment.

Fig. 10 is a perspective view of an electrostrictive effect element according to a third embodiment of the invention.

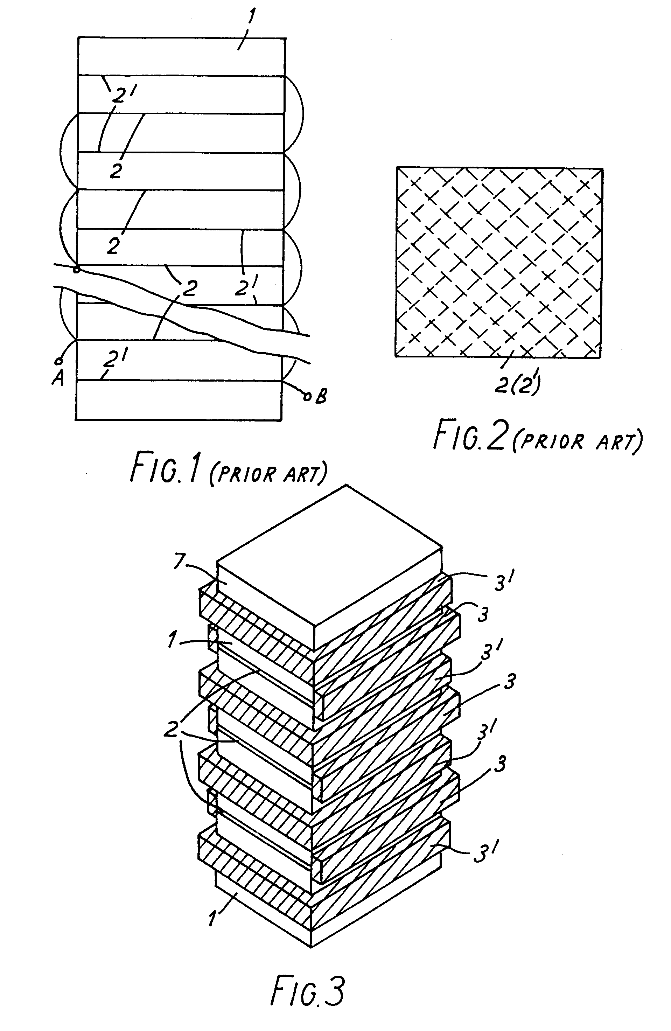

Figs. 1 and 2 show a laminated-type electrostrictive effect element which is disclosed in the specification of the aforementioned United States Patent No. 4,523,121. As will be seen from Fig. 1 which is a side elevational view, internal electrode plates 2, 2' and films or thin plates 1 of electrostrictive material are stacked in layers such that the internal electrode plate 2 and the internal electrode plate 2' appear alternatingly. The ends of the internal electrode plates 2 are connected to one another and also to an external terminal A, while the internal electrodes 2' are connected to an external terminal B. As shown in Fig. 2, the internal electrode plates 2 and 2' are formed on the entire area of the main surface of the film 1 so that a uniform electric field distribution is formed in the film 1 of the electrostrictive material to cause a uniform displacement of the element, as an electric voltage is applied between the external terminals A and B. In this laminated-type electrostrictive effect element, however, it is extremely difficult to achieve mutual electric connection of the internal electrode plates 2 and the mutual electric connection of the internal electrode plates 2'.

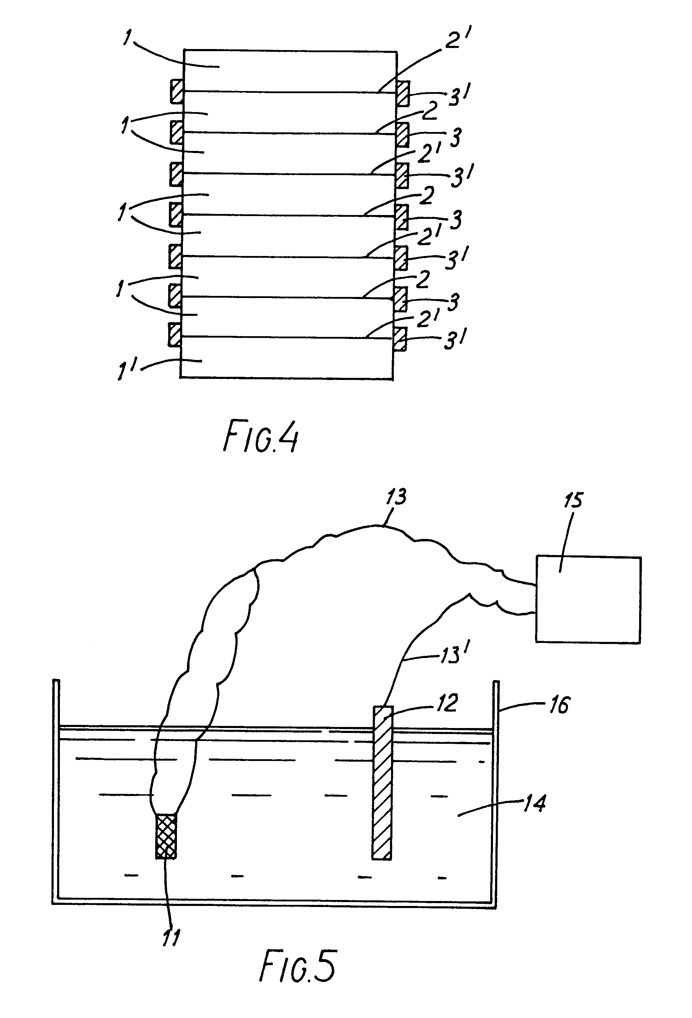

Figs. 3 and 4 are a perspective view and a sectional view of a first embodiment of the invention. It will be seen that, in the electrostrictive element of the invention, three of the four exposed side ends of the respective internal electrodes 2, 2' and their adjacent area of the side surfaces of the films 1 of the electrostrictive material only are coated by organic insulating layers 3 and 3'. Therefore, the strain of the insulating layers 3, 3' in response to the expansion or contraction of the electrostrictive material is minimized to completely eliminate the cracking in the insulating layers. Although not shown in Fig. 3, external electrodes are formed by separately coating the opposing two side faces of the laminated structure where the one side ends of the internal electrodes 2 and 2' are respectively exposed, with respective layers of silver-platinum paste.

A description will be made hereinunder of an embodiment of the method of the invention for producing the laminated-type electrostrictive effect element.

Powder of electrostrictive material consisting essentially of lead magnesium niobate Pb(Mg 1/3 Nb 2/3) is dispersed together with an organic binder in a solvent to form a slurry. A green ceramics sheet having a uniform thickness of 30 to 200 $\mu$m is formed from this slurry by a casting method employing a doctor blade. Rectangular sheets of 60 mm long and 40 mm wide are punch out from the green ceramics sheet and internal electrodes are formed on the surface of each sheet with platinum paste by screen printing method. A plurality of the rectangular, green ceramics sheets having the internal electrodes are stacked to form a laminated structure. This laminated structure is then sintered at a temperature of 900 to 1200°C to form a sintered laminated body.

The sintered body is then cut into square pieces having a side length of 5 mm by means of a diamond cutter. A pair of electrodes for external connection are formed on a suitable portions of side surfaces of the cut piece such that first every other internal electrodes are connected electrically into one group, while second every other internal electrodes are connected electrically into another group. After covering one side surface of the cut piece with a mask such as an adhesive tape or the like to provent unnecessary deposition to the one side surface thereof, this piece is immersed in an emulsion of epoxy resin. Epoxy resin layers as the organic insulating layers are deposited on exposed surfaces of the internal electrodes and the portions adjacent thereto, by applying a D.C. voltage of 50 V for 30 seconds between the external electrode connected to one group of the every other internal electrodes and an opposing electrode disposed in the cell. After the deposition of the insulating layers, the mask is removed and then the piece is subjected to a heat treatment at 170°C for 30 minutes to sinter the deposited layer so that it becomes an integral part of the element.

Thereafter, the other side surfaces of the piece is covered with the same mask as mentioned above and the above mentioned electrophoretic process is carried out in the same manner by applying D.C. voltage between another external electrode connected to the other group of the every other internal electrodes and the opposing electrode disposed in the electrophoretic cell. After sintering a second deposited organic insulating layer, a pair of external electrodes are formed on the portion of the side surfaces of the piece where the mask had been removed. For example, silver-platinum paste is screen printed and then subjected to a sintering process.

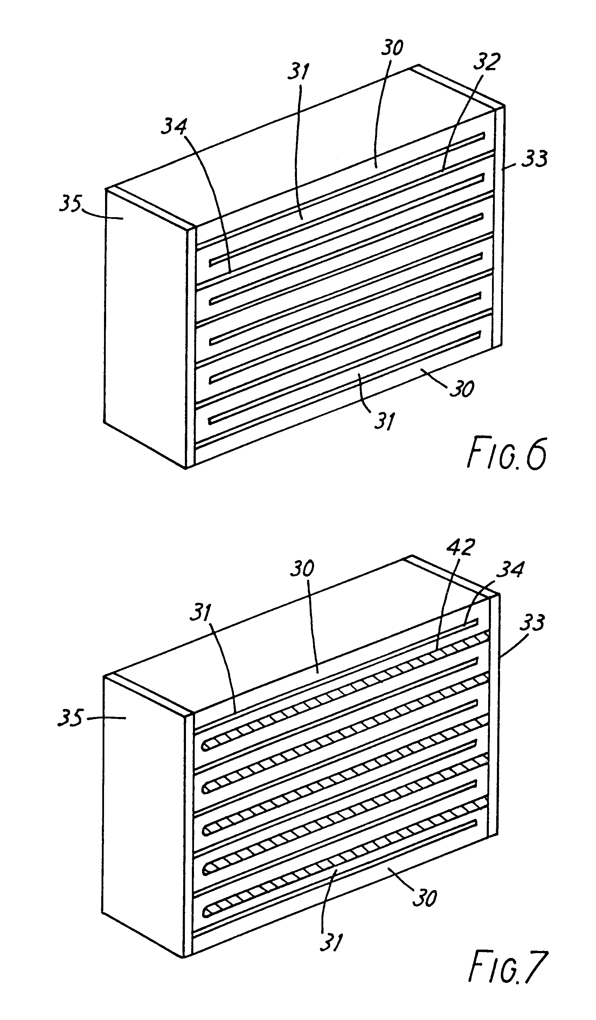

Fig. 5 shows an example of an apparatus for depositing insulating layers on the exposed internal electrodes by an electrophoretic process, suitable for use in the method of the invention. In this Figure, an emulsion and/or solution 14 of an electrodeposition paint is filled in a glass vessel 16, and an electrostrictive effect element 11 and an opposing electrode 12 are immersed in the emulsion and/or solution 14. They are connected to a D.C. power supply 15 by means of lead wires 13 and 13'.

The emulsion and/or solution used for the electrophoretic process in this embodiment contains 2 20 wt% of bisphenyl series epoxy cationic electrodiposition paint.

An A.C. voltage of 300 V at 50 Hz was applied for 100 hours to the electrostrictive effect element with the insulating layers thus formed thereon to cause cyclic expansion and contraction of the element, but no defect in electric characteristic such as insulation failure was caused nor troubles such as cracking and separation of the insulating layers were observed. It was thus confirmed that the element produced by this invention can be used practically as the electrostrictive element.

According to our experiment, it was found that the reliability of insulating layer is increased by adding hydrophobic filter such as $\alpha$-alumina, boron nitride, Teflon®, aluminium nitride or silica into the organic insulating layer. The filler is mixed with the starting emulsion or solution of the organic material and is deposited together with the organic material.

Table 1 shows experimental results for the effect of the filler. The experiments were carried out by using the electrostrictive effect element which has a distance of 115 $\mu$m between adjacent exposed internal electrodes. Under the load life test, D.C. 200 V was applied to the sample elements at 85°C for 500 hours and 1000 hours. The load humidity life test was carried out by applying D.C. 100 V to the sample elements for 500 hours and 1000 hours under the condition of 60°C and 90 - 95% RH.

As is apparent from Table 1, samples produced through emulsion or solution of the organic material containing the filler shows no failure after 1000 hours, while those samples without filler shows failure after 1000 hours. Case No. 10 shows the case where the element was not deposited with insulating material. In this case, all of the ten samples show failure after 500 hours. Case No. 11 shows the case where the element is entirely coated with organic material by dipping method. In this case, all the ten samples show failure after 1000 hours while eight of ten samples become failure after 500 hours.

It is desirable to limit the amount of filler so as not to exceed 50 vol % of organic material. Otherwise, voids will appear, which reduce the adhesiveness. By selecting the amount of filler from 6.3 vol % to 30 vol % of the organic material, various thickness of the deposited insulating layer can be obtained. Table 2 shows experimental results of the thickness of the deposited filler, contained resin layer. In this experiment, resin and filler are dispersed into water which contain organic solvent such as diethylenglycol-n-monobutylether. Some typical examples of the paint composition are as follows:

| epoxy series resin: | 15 wt%, | 25 wt%, | 40 wt% |
|---|---|---|---|
| filler: | 5 wt%, | 10 wt%, | 15 wt% |
| organic solvent: | 0.3 wt%, | 0.5 wt%, | 0.5 wt% |
| water: | 79.7 wt%, | 65.5 wt%, | 45.5 wt% |

Preferable range of the resin is between 5 wt% and 60 wt%. The grain size of the filler powder was 10 μm or less.

Table 1

| Case No. | Paint Composition | | Load Lifetime Test | | Load Humidity Lifetime Test | | Note |
|---|---|---|---|---|---|---|---|
| | Resin Series (Vol %) | Filler (Vol %) | Sample Number | Failure Number 500H / 1000H | Sample Number | Failure Number 500H / 1000H | |
| 1. | bisphenyle series epoxy 100 | — — | 10 | 0 / 5 | 10 | 0 / 8 | |
| 2. | " 85 | α-alumina 15 | 10 | 0 / 0 | 10 | 0 / 0 | |
| 3. | " 85 | boron nitride 15 | 10 | 0 / 0 | 10 | 0 / 0 | |
| 4. | " 80 | Teflon 20 | 10 | 0 / 0 | 10 | 0 / 0 | |
| 5. | strate epoxy 100 | — — | 10 | 0 / 3 | 10 | 0 / 7 | |
| 6. | " 80 | Teflon 20 | 10 | 0 / 0 | 10 | 0 / 0 | |
| 7. | " 80 | α-alumina 20 | 10 | 0 / 0 | 10 | 0 / 0 | |
| 8. | Polybutadiene series resin 90 | α-alumina 10 | 10 | 0 / 0 | 10 | 0 / 0 | |
| 9. | " 90 | Teflon 10 | 10 | 0 / 0 | 10 | 0 / 0 | |
| 10. | ' — | — — | 10 | 10 / 10 | 10 | 10 / 10 | without coating |
| 11. | epoxy series resin 80 | silica 20 | 10 | 8 / 10 | 10 | 8 / 10 | coating by dipping |

Table 2

| Sample No. | Paint Composition | | | Electrophoretic Condition | | Sintering Condition | | Thickness (μm) |
|---|---|---|---|---|---|---|---|---|
| | Resin Series | Filler | (Vol %) | Voltage (V) | Time (minute) | Temperature (°C) | Time (minute) | |
| 12. | epoxy series cationic resin | α-alumina | 6.3 | 40 | 3 | 175 | 30 | 5 |
| 13. | " | " | 6.3 | 250 | 3 | 175 | 30 | 50 |
| 14. | " | " | 10 | 40 | 3 | 175 | 30 | 5 |
| 15. | " | " | 10 | 250 | 3 | 175 | 30 | 200 |
| 16. | " | " | 15 | 30 | 3 | 175 | 30 | 5 |
| 17. | " | " | 15 | 250 | 12 | 175 | 30 | 75 |
| 18. | " | " | 20 | 30 | 3 | 175 | 30 | 15 |
| 19. | " | " | 20 | 250 | 13 | 175 | 30 | 50 |
| 20. | " | " | 30 | 7 | 3 | 175 | 30 | 20 |
| 21. | " | " | 30 | 250 | 10 | 175 | 30 | 200 |
| 22. | " | Teflon | 10 | 60 | 3 | 175 | 30 | 20 |
| 23. | " | " | 20 | 125 | 3 | 175 | 30 | 20 |
| 24. | " | boron nitride | 10 | 100 | 3 | 175 | 30 | 20 |
| 25. | " | aluminium nitride | 10 | 40 | 3 | 175 | 30 | 20 |
| 26. | " | " | 10 | 250 | 3 | 175 | 30 | 50 |

Figs. 6 to 9 show a second embodiment of the invention.

First of all, prepared is a laminated structure of an electrostrictive material 30, 31, having a multiplicity of internal electrodes 32 and 34 and external electrodes 33 and 35 through which the internal electrodes 32 and 34 are connected at the exterior, as shown in Fig. 6. The internal electrodes 32 and 34 are exposed at the end surfaces of the laminated structure. First every other layers 32 of the internal electrodes are

6

connected electrically into one group, while second every other layers 34 of internal electrodes are connected electrically into another group. These groups are connected to two temporary external electrodes 33 and 35, respectively. In order to deposit the insulation material to the exposed portion of the internal electrode sandwiched between adjacent layers 31 of the electrostrictive material, and the areas around the exposed portion, the laminated structure is immersed in a solution containing charged paint (not shown), after covering the back side surface of the laminated structure by a mask such as an adhesive tape or the like to prevent unnecessary deposition to the reverse side. Then, an opposite electrode plate (not shown) is placed in front of the front side surface of the laminated structure, and a D.C. voltage is imposed between the opposing electrode and the external electrode 33. Consequently, the positively charged paint is forced to move in the solution by the force produced by the electric field which is directed from the opposing electrode plate towards the exposed portions of the internal electrodes 32 connected to the external electrodes 33, so that the paint 42 is deposited only on the exposed portion of the internal electrodes 32 connected to the external electrode 33 and the portions of the exposed surface of the material 30 and 31 around these exposed portions but not to the exposed portions of the internal electrodes 34 connected to the external electrode 35, as shown in Fig. 7. The laminated structure is then withdrawn from the solution and is dried and then fired to sinter the paint, so that belt-like organic insulating films 42 are formed to cover the exposed portions of every other layers of the internal electrode 32. The laminated structure having such belt-like insulating films 42 will be best seen from Fig. 7. It will be understood from this Figure that the belt-like insulating films 42 are formed on every other layers of the internal electrode 32, while the exposed portions of the internal electrodes 34 are left unconvered. A reference numeral 30 designates the electrostrictive material constituting the protecting film portion.

In the same manner, the organic insulation layer is provided also on the back side surface of the laminated structure in the same pattern as the front side. To this end, the laminated structure is immersed in the solution (not shown) after covering the front side surface of the same with an adhesive tape or the like to avoid unnecessary attaching of the paint. Then, the opposing electrode plate (not shown) is placed in front of the back side and voltage is applied between the opposing electrode plate and the external electrode 35, thereby to deposit the paint onto the exposed portions of the internal electrodes 34. Subsequently, the laminated structure is subjected to a firing to sinter the paint thereby to form belt-like coating films of the organic insulation material.

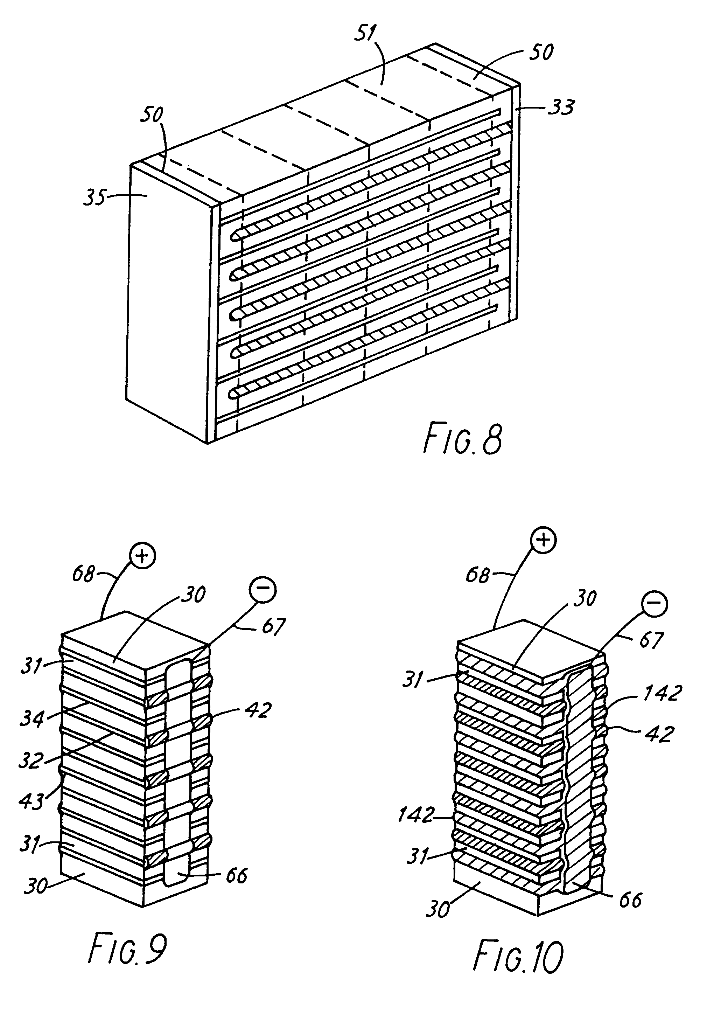

Then, the laminated structure of electrostrictive material having belt-like paint films on both sides is cut along the broken lines in Fig. 8 into the final size of the electrostrictive effect element. At least the two portions 50 near the external electrodes have to be cut away. Two small pieces 50 with the temporary external electrodes 33, 35 cannot be used as the electrostrictive effect element. By effecting the cutting in the manner shown in Fig. 8, a plurality of electrostrictive effect element 51 are obtained from one laminated structure of the electrostrictive material. It is possible to electrically connect the electrostrictive effect elements by forming external electrodes 66 on the front and back side surfaces of the elements across the belt-like coating films and the exposed internal electrodes as shown in Fig. 9 by a screen printing method with a silver-platinum paste. Numerals 67 and 68 denote external terminals. These external electrodes 66 can be provided and sintered prior to cutting the laminated structure of electrostrictive material to fascilitate the manufacturing process. After sintering the silver-platinum paste, these elements are again subjected to electrophoretic process to cover all of exposed side ends of internal electrodes. In this final electrophoretic process, organic insulating layer is deposited not only on the remaining exposed side ends of the internal electrodes but also on the pair of external electrodes.

Since the external electrodes are only covered with organic material, the effect of the expansion or contraction of the element is not reduced.

In the forgoing embodiments, all electrophoretic processes are carried out by using organic material, and the portions of the organic insulating layer sandwiched between the external electrodes and the side ends of the internal electrodes are subjected to a strong electric field. In view of a reliavility and life time of the element, it is favorable to replace the sandwiched portion of the organic insulating layer by inorganic insulating material such as glass in order to further increase the reliability of the element. In this case, the electrophoretic processes are carried out twice, once by using a suspension of glass powder and then with an emulsion or solution of resin material.

To this end, a third embodiment of the invention is described by referring to Fig. 10 as well as Fig. 6 to 9, For the description of the process for forming the glass layer, Figs. 6 to 9 are again referred to.

First of all, prepared is a laminated structure of an electrostrictive material 30, 31, having a multiplicity of internal electrodes 32 and 34 and external electrodes 33 and 35 through which the internal electrodes 32 and 34 are connected at the exterior, as shown in Fig. 6. The internal electrodes 32 and 34 are exposed at the end surfaces of the laminated structure. First every other layers 32 of the internal electrodes are connected electrically into one group, while second every other layers 34 of internal electrodes are connected electrically into one group. These groups are connected to two temporary external electrodes 33 and 35, respectively. In order to deposit the glass layer to the exposed portion of the internal electrode sandwiched between adjacent layers 31 of the electrostrictive material, and the areas around the exposed portion, the laminated structure is immersed in a suspension solution containing charged glass powder (not shown), after covering the back side surface of the laminated structure by a mask such as an adhesive tape or the like to prevent unnecessary deposition to the reverse side. Then, an opposite electrode plate (not shown) is placed in front of the front side surface of the laminated structure, and a D.C. voltage is imposed between the opposing electrode and the external electrode 33. Consequently, the positively charged glass powder is forced to move in the suspension solution by the force produced by the electric field which is directed from the opposing electrode plate towards the exposed portions of the internal electrodes 32 connected to the external electrodes 33, so that the glass powder 42 is deposited only on the exposed portion of the internal electrodes 32 connected to the external electrode 33 and the portions of the exposed surface of the material 30 and 31 around these exposed portions but not to the exposed portions of the internal electrodes 34 connected to the external electrode 35, as shown in Fig. 7.

In this embodiment, a slurry 14 of the glass powder is filled in a glass vessel 16 in Fig. 5.

The slurry used for the electrophoretic process in this embodiment had the following composition.

| zinc borosilicate glass: | 10 wt% |
| ethanol: | 85 wt% |
| polyvinyl butyral: | 5 wt% |

The grain size of the zinc borosilicate glass powder was 1.5 $m^2/g$ in terms of BET value.

The laminated structure is then withdrawn from the suspension liquid and is dried and then fired at 710°C for 10 minutes to sinter the glass powder, so that belt-like glass coating films 42 are formed to cover the exposed portions of every other layers of the internal electrode 32.

In the same manner, the gloss insulation layer is provided also on the back side surface of the laminated structure in the same pattern as the front side. To this end, the laminated structure is immersed in the suspension liquid (not shown) after covering the front side surface of the same to avoid unnecessary attaching of the glass powder. Then, the opposing electrode plate (not shown) is placed in front of the back side and voltage is applied between the opposing electrode plate and the external electrode 35, thereby to deposit the glass powder onto the exposed portions of the internal electrodes 34. Subsequently, the laminated structure is subjected to a firing to sinter the glass powder thereby to form belt-like coating films of glass. Thereafter, a plurality of external electrodes 66 are formed on the front and back side surfaces of the elements across the belt-like glass coating films and the exposed internal electrodes as shown in Fig. 9 by a screen printing method with a silver-platinum paste.

After sintering the silver-platinum paste, the laminated structure of electrostrictive material having belt-like glass coating films on both sides is cut along the broken line shown in Fig. 8 into the final size of the electrostrictive effect element. At least the two portions 50 near the external electrodes have to be cut away. By effecting the cutting in the manner shown in Fig. 8, a plurality of electrostrictive effect elements 51, one of which is shown in Fig. 9, are obtained from one laminated structure of the electrostrictive material.

Then, the element shown in Fig. 9 is immersed in an emulsion of epoxy resin, and subjected to the electrophoretic process in the same manner as described above. Epoxy resin layers as the organic insulating layers 142 and 132 are deposited on the remaining exposed surfaces of the internal electrodes (not covered by the glass layer 42) adjacent to the external electrodes and on all of the newly exposed surfaces of the internal electrodes appearing on the cut surfaces. At this time, the epoxy resin layers 142 are also deposited on the surfaces of the external electrodes 66 as shown in Fig. 10.

In this embodiment, the organic layers 132 and 142 cover all the exposed side ends of the internal electrodes except for the portion coated with the inorganic layer 42 and therefore high reliability and long lifetime are achieved without reducing the electrostrictive effect.

**Claims**

1.  A method of producing an electrostrictive effect element comprising the steps of: preparing a laminated structure in which a plurality of films or thin plates of electrostrictive material (1) alternate with a plurality of layers of internal electrodes (2,2'), each film or plate has a principal surface thereof facing a principal surface of a layer, and said laminated structure has flat side surfaces which are perpendicular to said principal surfaces and upon which cross sections of said internal electrodes are exposed; and selectively depositing organic material (3,3') on the exposed cross sections or on portions of the exposed cross sections of said internal electrodes and on adjacent areas of the electrostrictive material; characterised by depositing said organic material (3,3') by an electrophoretic process after placing said laminated structure (11) in a solution (14) containing said organic material; and thereafter sintering the deposited organic material to produce organic insulation layers.

2.  A method of producing an electrostrictive effect element according to Claim 1, wherein said solution containing said organic material further contains a hydrophobic filler selected from α-alumina, boron nitride, Teflon$^R$, aluminum nitride and silica.

3.  A method of producing an electrostrictive effect element according to Claim 1, wherein said organic material is epoxy resin.

4.  A method of producing an electrostrictive effect element as claimed in Claim 1, wherein said step of depositing organic material includes the steps of attaching external electrodes (33,35) to cross sections of the internal electrodes (32,34) which are exposed along a pair of opposed end surfaces of the flat side surfaces of the laminated structure, immersing the laminated structure in an electrophoretic cell containing a solution and/or emulsion of organic material, and applying a D.C. voltage between the external electrodes and an opposing electrode (12) disposed in the cell, thereby to deposit the organic material (42) on the cross sections of the internal electrodes which are exposed on the flat side surfaces of the laminated structure and on the adjacent areas of electrostrictive material.

5.  A method as claimed in Claim 4, further including the step of maintaining cross sections of alternate ones of the internal electrodes on a flat side surface of the laminated structure exposed during the deposition of the organic material, and applying a paste of conductive material (66) to the exposed cross sections of the remaining internal electrodes.

6.  A method of producing an electrostrictive effect element as claimed in Claim 1, further including the steps of attaching an external electrode (33) to alternate ones of said internal electrodes (32) which form a first group exposed along one end surface of the flat side surfaces of of the laminated structure, attaching another external electrode (35) to the remaining internal electrodes (34) which form a second group exposed along a second end surface of the flat side surfaces of said laminated structure, covering a third side surface of said laminated structure with a mask to prevent deposition of the organic material thereon, immersing the laminated structure in a solution and/or emulsion containing a charged organic material, placing an opposing electrode plate (12) in said solution and/or emulsion, and connecting a D.C. voltage source to one of the external electrodes and the opposing electrode plate (12) so as to deposit strips of organic material (42) only on cross sections of the internal electrodes which are exposed on a fourth side surface of said laminated structure and are connected to said external electrode (33) attached to the D.C. voltage source and on adjacent areas of the electrostrictive material.

7.  A method of producing an electrostrictive effect element as claimed in Claim 6, further including the step of cutting said laminated structure into at least three portions in the direction of the lamination, each of two of said portions containing one of said external electrodes (33,35) and a third portion (51) of the laminated structure forming at least one electrostrictive effect element.

8.  A method of producing an electrostrictive effect element according to Claim 1, further including the step of respectively forming first and second external conductive layers (66) on said flat side surfaces of the laminated structure to electrically connect said first and second external conductive layers with exposed cross sections of said internal electrodes (32,34) after forming said organic insulating layers (42) on alternate ones of the exposed cross sections of the internal electrodes.

9.  A method of producing an electrostrictive effect element according to Claim 1, wherein each of said films or thin plates of electrostrictive material has a substantially uniform thickness of 30 to 200 $\mu$m.

**Revendications**

1. Procédé pour produire un élément à effet électrostrictif comprenant les étapes consistant à : préparer une structure stratifiée dans laquelle une multitude de films ou plaques minces de matériau électrostrictif (1) sont en alternance avec une multitude de couches d'électrodes internes (2, 2'), chaque film ou plaque comporte une surface principale de celle-ci faisant face à une surface principale d'une couche et la structure stratifiée comporte des surfaces latérales plates qui sont perpendiculaires aux surfaces principales et sur lesquelles des sections transversales des électrodes internes sont exposées ; et à déposer de manière sélective le matériau organique (3, 3') sur les sections transversales exposées ou sur les parties des sections transversales exposées des électrodes internes et sur les zones adjacentes du matériau électrostrictif ; caractérisé par l'étape consistant à déposer le matériau organique (3, 3') par un processus d'électrophorèse après avoir placer la structure stratifiée (11) dans une solution (14) contenant le matériau organique ; et par la suite fritter le matériau organique déposé pour produire des couches isolantes organiques,

2. Procédé pour produire un élément à effet électrostrictif selon la revendication 1, dans lequel la solution contenant le matériau organique contient de plus un matériau de remplissage hydrophobe choisi parmi α-alumina, nitrure de bore, téflon®, nitrure d'aluminium et dioxyde de silicium.

3. Procédé pour produire un élément à effet électrostrictif selon la revendication 1, dans lequel le matériau organique est de la résine époxy.

4. Procédé pour produire un élément à effet électrostrictif selon la revendication 1, dans lequel l'étape pour déposer du matériau organique comporte les étapes consistant à fixer les électrodes externes (33, 35) aux sections transversales des électrodes internes (32, 34) qui sont exposées le long d'une paire de surfaces d'extrémités opposées des surfaces latérales plates de la structure stratifiée, à plonger la structure stratifiée dans une cuve d'électrophorèse contenant une solution et/ou émulsion de matériau organique et à appliquer une tension à courant continu entre les électrodes externes et une électrode opposée (12) disposée dans la cuve, pour déposer de ce fait le matériau organique (42) sur les sections transversales des électrodes internes qui sont exposées sur les surfaces latérales plates de la structure stratifiée et sur les zones adjacentes du matériau électrostrictif.

5. Procédé selon la revendication 4, comportant de plus l'étape consistant à maintenir les sections transversales des électrodes alternées des électrodes internes sur une surface latérale plate de la structure stratifiée exposée pendant le dépôt du matériau organique et à appliquer une pâte de matériau conducteur (66) aux sections transversales exposées des électrodes internes restantes.

6. Procédé pour produire un élément à effet électrostrictif selon la revendication 1, comportant de plus les étapes consistant à fixer une électrode externe (33) aux électrodes alternées des électrodes internes (32) qui forment un premier groupe exposé suivant une première surface d'extrémité des surfaces latérales plates de la structure stratifiée, à fixer une autre électrode externe (35) aux électrodes internes restantes (34) qui forme un second groupe exposé le long d'une seconde surface d'extrémité des surfaces latérales plates de la structure stratifiée, à recouvrir une troisième surface latérale de la structure stratifiée avec un masque pour empêcher le dépôt du matériau organique sur celle-ci, à plonger la structure stratifiée dans une solution et/ou émulsion contenant un matériau organique chargé, à placer une plaque d'électrode opposée (12) dans la solution et/ou émulsion et à raccorder une source de tension à courant continu à une des électrodes externes et à la plaque d'électrode opposée (12) de façon à déposer des bandes de matériau organique (42) seulement sur les sections transversales des électrodes internes qui sont exposées sur une quatrième surface latérale de la structure stratifiée et sont connectées à l'électrode externe (33) reliée à la source de tension à courant continu et sur les zones adjacentes de matériau électrostrictif.

7. Procédé pour produire un élément à effet électrostrictif selon la revendication 6, comprenant de plus l'étape consistant à découper la structure stratifiée en au moins trois parties dans le sens de l'empilage, chacune des deux parties contenant une des électrodes externes (33, 35) et une troisième partie (51) de la structure stratifiée formant au moins un élément à effet électrostrictif.

8. Procédé pour produire un élément à effet électrostrictif selon la revendication 1, comportant de plus l'étape consistant à former respectivement des première et seconde couches conductrices externes (66) sur les surfaces latérales plates de la structure stratifiée pour connecter électriquement les première et seconde couches conductrices externes aux sections transversales exposées des électrodes internes (32, 34) après formation des couches isolantes organiques (42) sur les sections transversales alternées des sections transversales exposées des électrodes internes.

9. Procédé pour produire un élément à effet électrostrictif selon la revendication 1, dans lequel chacun des films ou plaques minces du matériau électrostrictif présente une épaisseur pratiquement uniforme de 30 à 200 $\mu$m.

**Patentansprüche**

1. Verfahren zur Herstellung eines elektrostriktiven Elements mit den Schritten: Herstellen einer Laminatstruktur, in der Filme oder dünne Platten aus elektrostriktivem Material (1) und Innenelektrodenschichten (2,2') miteinander abwechseln, wobei eine Hauptfläche jedes Films oder jeder Platte einer Hauptfläche einer Schicht gegenüberliegt und die Laminatstruktur flache Seitenflächen aufweist, die senkrecht zu denHauptflächen sind und an denen Querschnittsflächen der Innenelektroden freiliegen; und selektives Aufbringen von organischem Material (3,3') auf den freiliegenden Querschnittsflächen oder Teilen der Querschnittsflächen der Innenelektroden und auf benachbarten Bereichen des elektrostriktiven Materials, **gekennzeichnet** durch Abscheidendes organischen Materials (3,3') durch einen Elektrophoreseprozeß nach Einbringen der Laminatstruktur (11) in eine das organische Material enthaltende Lösung (4); und anschließendes Sintern des abgeschiedenen organischen Materials zur Erzeugung von organischen Isolierschichten.

2. Verfahren nach Anspruch 1, dadurch **gekennzeichnet**, daß die das organische Material enthaltende Lösung zusätzlich einen hydrophoben Füllstoff aus $\alpha$-Aluminiumoxid, Bohrnitrid, Teflon$^R$, Aluminiumnitrid oder Siliziumoxid beinhaltet.

3. Verfahren nach Anspruch 1, dadurch **gekennzeichnet**, daß das organische Material ein Epoxidharz ist.

4. Verfahren nach Anspruch 1, dadurch **gekennzeichnet**, daß der Schritt des Abscheidens des organischen Materials die folgenden Schritte umfaßt: Befestigen von Außenelektroden (33,35) an Querschnittsflächen der Innenelektroden (32,34), die entlang zweier gegenüberliegender Endoberflächen der flachen Seitenflächen der Laminatstruktur freiliegen, Eintauchen der Laminatstruktur in eine eine Lösung und/oder Emulsion des organischem Materials enthaltende elektrophoretische Zelle und Anlegen einer Gleichspannung zwischen den Außenelektroden und einer gegenüberliegenden Elektrode (12), die in der Zelle angeordnet ist wodurch das organische Material (42) auf den Querschnittsflächen der Innenelektroden abgeschieden wird, die an den flachen Seitenflächen der Laminatstruktur und an den benachbarten Bereichen des elektrostriktiven Materials freiliegen.

5. Verfahren nach Anspruch 4, dadurch **gekennzeichnet**, daß während der Abscheidung des organischen Materials die Querschnittsflächen von alternierenden Innenelektroden auf einer flachen Seitenfläche der Laminatstruktur, während der Abscheidung des organischen Materials freiliegend gelassen werden und daß ein leitendes Material (66) auf die freiliegenden Querschnittsflächen der verbleibenden Innenelektroden aufgebracht wird.

6. Verfahren nach Anspruch 1, **gekennzeichnet** durch die Schritte: Befestigen einer Außenelektrode (33) an alternierenden Innenelektroden (32), die eine erste Gruppe bilden, welche entlang einer Endoberfläche der flachen Seitenflächen der Laminatstruktur freiliegen, Befestigen einer anderen Außenelektrode (35) an den verbleibenden Innenelektroden (34), die eine zweite Gruppe bilden, welche entlang einer zweiten Endoberfläche der flachen Seitenflächen der Laminatstruktur freiliegen, Bedecken einer dritten Seitenfläche der Laminatstruktur mit einer Maske, um ein Abscheiden des organischen Materials zu verhindern, Eintauchen der Laminatstruktur in eine Lösung und/oder Emulsion, die geladenes organisches Material enthält, Anordnen einer gegenüberliegenden Elektrodenplatte (12) in der Lösung und/oder Emulsion und Verbinden einer Gleichspannungsquelle mit einer der Außenelektroden und mit der gegenüberliegenden Elektrodenplatte (12), so daß Streifen von organischem Material (42) nur auf Querschnittsflächen derjenigen Innenelektroden, welche an einer vierten Seitenfläche der Laminalstruktur freiliegen und mit der an die Gleichspannungsquelle angeschlossenen Außenelektrode (33) verbunden sind, an der Gleichspannungsquelle und auf daran angrezenden Bereichen des elektrostriktiven Materials abgeschieden werden.

7. Verfahren nach Anspruch 6, **gekennzeichnet** durch den Schritt: Schneiden der Laminatstruktur in Richtung der Laminierung in mindestens drei Teile, wobei zwei dieser Teile je eine der Außenelektroden (33, 35) aufweisen und der dritte Teil (51) der Laminatstruktur mindestens ein elektrostriktives Element bildet.

8. Verfahren nach Anspruch 1, **gekennzeichnet** durch den Schritt: Bilden einer ersten bzw. zweiten externen, leitenden Schicht (66) auf den flachen Seitenflächen der Laminatstruktur, um die erste und zweite externe, leitende Schicht mit freiliegenden Querschnittsflächen der Innenelektroden (32, 34) elektrisch zu verbinden, nachdem die organischen Isolierschichten (42) auf alternierende, freiliegende Querschnittsflächen der Elektroden gebildet wurden.

9. Verfahren nach Anspruch 1, dadurch **gekenn**zeichnet, daß jeder Film oder jede dünne Platte des elektrostriktiven Materials im wesentlichen eine gleichförmige Dicke von 30-200 $\mu$m aufweist.

FIG.1 (PRIOR ART)

FIG.2 (PRIOR ART)

FIG.3

FIG.4

FIG.5

FIG.6

FIG.7

EP 0 167 392 B1

FIG.8

FIG.9

FIG.10